# EUROPÄISCHE PATENTSCHRIFT

(11) **EP 3 329 564 B1**
(45) Veröffentlichungstag und Bekanntmachung des Hinweises auf die Patenterteilung: **09.06.2021**
(21) Anmeldenummer: 16729898.3
(22) Anmeldetag: 16.06.2016
(51) Int. Cl.: H01T 2/02, H01T 15/00, H02H 9/06

(54) **SCHALTUNGSANORDNUNG ZUR ELEKTRONISCHEN ANSTEUERUNG VON TRIGGERBAREN ÜBERSPANNUNGSABLEITERN**
CIRCUIT ASSEMBLY FOR ELECTRONICALLY ACTUATING TRIGGERABLE SURGE ARRESTERS
AGENCEMENT DE CIRCUIT POUR LA COMMANDE ÉLECTRONIQUE DE DÉCHARGEURS DE SURTENSION DÉCLENCHABLES

(30) Priorität: 27.07.2015 DE 102015009771; 13.10.2015 DE 102015013222
(43) Veröffentlichungstag der Anmeldung: 06.06.2018
(73) Patentinhaber: DEHN SE + Co KG, 92318 Neumarkt / Opf. (DE)
(72) Erfinder: BÖHM, Thomas, 92366 Hohenfels (DE); SPIES, Johannes, 92318 Neumarkt (DE); SCHORK, Franz, 90461 Nürnberg (DE); BROCKE, Ralph, 98693 Ilmenau / Oberpörlitz (DE)
(74) Vertreter: Prinz & Partner mbB
(86) Internationale Anmeldenummer: PCT/EP2016/063813
(87) Internationale Veröffentlichungsnummer: WO 2017/016745

(56) Entgegenhaltungen:
- DE-A1- 3 223 392
- DE-A1-102004 002 581
- DE-A1-102013 108 658
- US-A- 4 703 385

## Beschreibung

Die Erfindung betrifft eine Schaltungsanordnung zur elektronischen Ansteuerung von triggerbaren Überspannungsableitern wie Funkenstrecken oder Mehrelektroden Gasableiter, wobei mindestens ein Leistungshalbleiter von einer Schaltstufe bei Erkennung eines Überspannungsereignisses aktiviert wird und der Leistungshalbleiter ausgangsseitig mit einem Triggereingang des Überspannungsableiters in Verbindung steht, gemäß Anspruch 1.

Zur Ableitung von hohen Impulsströmen, besonders bei direkten Blitzeinschlägen, werden in bekannter Weise Überspannungsschutzkomponenten, typischerweise Überspannungsableiter auf der Basis der Funkenstreckentechnologie oder aber auch Gasableiter eingesetzt. Nachteilig ist die bei Funkenstrecken üblicherweise hohe Ansprechspannung, da zunächst durch die anliegende Überspannung erst ein Funkenüberschlag und eine Ionisierung zwischen den Elektroden der Funkenstrecken stattfinden muss und hiernach ein spannungssteiiheitsabhängiges Ansprechen stattfindet, welches bei hohen Steilheiten zu höheren Schutzpegeln führt. Aus diesem Grund sind Triggerschaltungen vorgeschlagen worden, die niedrigere Schutzpegel, wie z.B. 1,5 kV für Geräte im 230 V Versorgungsnetz ermöglichen. Übliche Triggerschaltungen bestehen aus Varistoren, Gasentladungsableitern, Suppressordioden oder Kapazitäten und erzeugen ein Triggersignal, das einer entsprechenden Triggerelektrode einer Funkenstrecke zugeführt wird und diese sicher zündet.

Durch konstruktive Maßnahmen ist es gelungen, Funkenstrecken zu entwickeln, welche bereits über ein verbessertes Ansprechverhalten verfügen und die durch Nachschaltung einer Deionkammer quasi nichtausblasend realisierbar sind.

Diesbezüglich sei auf die DE 10 2011 102 257 A1 aufmerksam gemacht, welche eine Hörnerfunkenstrecke mit Deionkammer in nichtausblasender Bauform mit einem mehrteiligen Isolierstoffgehäuse als Stütz- und Aufnahmekörper für die Hörnerelektroden offenbart. Gemäß der dortigen Lösung ist der Lichtbogenlaufbereich zwischen den Elektroden in Richtung Deionkammer durch ein plattenförmiges Isolierstoffmaterial begrenzt, wobei das plattenförmige Isoliermaterial in entsprechenden Ausformungen in der Halbschale formschlüssig eingesetzt wird. Zusätzlich ist eine ferromagnetische Hinterlegung vorgesehen, um den Lichtbogenlauf zu beeinflussen. Weiterhin sind Mittel vorhanden, um die Gasströmung innerhalb der Hörnerfunkenstrecke zu beeinflussen und das Betriebsverhalten eines derartigen Überspannungsableiters zu verbessern.

Aus der WO 2012/022547 A1 ist eine Anordnung zur Zündung von Funkenstrecken mit Hilfe einer isolierten Triggerelektrode vorbekannt, wobei die Triggerelektrode mit einer der weiteren Hauptelektroden über mindestens ein spannungsschaltendes oder spannungsüberwachendes Element elektrisch verbunden ist und sich zwischen der Triggerelektrode und der weiteren Hauptelektrode ein Luftspalt befindet. Gemäß der dortigen Lösung bildet die Triggerelektrode mit der Isolationsstrecke und einer Schicht aus einem Material mit geringerer Leitfähigkeit als das Material einer der Hauptelektroden eine Sandwichstruktur. Die Sandwichstruktur stellt ein Schichtdielektrikum in der Reihenschaltung einer ersten Teilkapazität mit dem Dielektrikum der Isolationsstrecke und einer zweiten Teilkapazität mit dem Material als Dielektrikum dar. Mit einer derartigen Lösung sind Schutzpegel im Bereich von 1,5 kV für 230/400 V Niederspannungsnetze erreichbar

Weitere Schaltungsanordnungen zur Zündung von Funkenstrecken sind aus der Druckschriften US4703385 A, DE102004002581 A1 und DE3223392 A1 bekannt.

Für viele aktuelle Anwendungsfälle hat es sich jedoch gezeigt, dass die bisherigen Schutzpegel nicht ausreichend sind, wodurch eine Gefährdung nachgeschalteter elektronischer Komponenten nicht ausgeschlossen werden kann.

Aus dem Vorgenannten ist es daher Aufgabe der Erfindung, eine weiterentwickelte Schaltungsanordnung zur elektronischen Ansteuerung von triggerbaren Überspannungsableitern wie Funkenstrecken oder Mehrelektroden-Gasableiter anzugeben, wobei deutlich geringere Schutzpegel als bisher üblich erreicht werden sollen. Darüber hinaus ist sicherzustellen, dass die Schaltungsanordnung unempfindlich gegenüber der verketteten Netzspannung ist, und es soll ein unmittelbarer Einsatz bei verschiedenen Netzspannungen möglich sein. Darüber hinaus ist ein Ansatz zu schaffen, der eine Überwachung bzw. Diagnose des Betriebsverhaltens und damit der Belastungen des jeweilig eingesetzten Überspannungsableiters gewährleistet. Die Schaltungsanordnung ist so auszuführen, dass selbige grundsätzlich für die Ansteuerung von Funkenstrecken, aber auch von Mehrelektroden-Gasableitern geeignet ist.

Die Lösung der Aufgabe der Erfindung erfolgt durch die Merkmalskombination nach Patentanspruch 1, wobei die Unteransprüche mindestens zweckmäßige Ausgestaltungen und Weiterbildungen umfassen.

Es wird demnach von einer Schaltungsanordnung zur elektronischen Ansteuerung von triggerbaren Überspannungsableitern ausgegangen. Diese Überspannungsableiter können Funkenstrecke, insbesondere Hörnerfunkenstrecken, aber auch Mehrelektroden-Gasableiter oder dergleichen Mittel sein.

Die Schaltungsanordnung umfasst mindestens einen Leistungshalbleiter, der von einer Schaltstufe bei Erkennung eines Überspannungsereignisses aktiviert wird. Der Leistungshalbleiter steht ausgangsseitig mit einem bzw. dem jeweiligen Triggereingang des eingesetzten Überspannungsableiters in Verbindung.

Erfindungsgemäß ist die Schaltstufe als Steuer- und Auswerteeinheit für die Erkennung transienter Überspannungsereignisse ausgebildet. Hierfür besitzt die Steuer- und Auswerteeinheit erstens eine Impulserkennungsstufe, welche eine Impulserkennung pegelsensitiv oder steilheitsabhängig ermöglicht. Zweitens ist ein

Mikrokontroller zur Ereignisbewertung vorgesehen, wobei der Mikrokontroller ausgangsseitig auf den Steuerungseingang des Leistungshalbleiters führt.

Zwischen dem Ausgang des Leistungshalbleiters und dem Triggereingang des Überspannungsableiters ist ein schnellschaltender Gleichrichter auf der Basis diskreter, schneller IGBT-Dioden vorgesehen, um Überspannungen unterschiedlicher Polaritäten beherrschen zu können.

Durch den eingesetzten schnellschaltenden Gleichrichter vereinfacht sich die Schaltung, da nur noch ein relativ kostenintensiver Leistungshalbleiter eingesetzt werden muss.

In Ausgestaltung der Erfindung führt zur Vermeidung eines verzögerten Aktivierens des Überspannungsableiters die Impulserkennungsstufe unmittelbar auf den Steuerungseingang des Leistungshalbleiters. Zum selben Zweck kann ein Clampingbetrieb des Leistungshalbleiters vorgesehen sein.

Nach dem gewünschten schnellen Ansteuern des Leistungshalbleiters im Bereich von im Wesentlichen kleiner 50 ns übernimmt der Mikrokontroller der Steuer- und Auswerteeinheit den weiteren Betrieb und gibt diesen vor, in dem ein sicheres Durchzünden des Überspannungsableiters und ein anschließend zeitgesteuertes Abschalten des Triggerpfads vorgenommen wird bzw. erfolgt.

In einer Ausgestaltung der Erfindung, die insbesondere für den Einsatz der Schaltungsanordnung bei Mehrelektroden-Gasableitern als Überspannungsableitern zweckmäßig ist, wird zwischen dem Ausgang des Leistungshalbleiters und dem Triggereingang ein Übertrager bzw. Transformator eingesetzt.

Als Leistungshalbleiter kommen bevorzugt IGBTs oder MosFETs zum Einsatz.

In Weiterbildung der Erfindung, insbesondere zum angestrebten Zweck der Diagnose und Zustandsüberwachung der Schaltungsanordnung bzw. zur Analyse der Belastungssituation eines angeschlossenen Überspannungsableiters weist der Mikrokontroller eine Einheit zur Speicherung und/oder Anzeige von Überspannungsereignissen mit Triggeraustösung auf.

Die Signalwerte, bei welchen die Steuer- und Auswerteeinheit anspricht, sind entweder herstellerseitig vorgebbar oder aber auch extern einstellbar, insbesondere über den Mikrokontroller programmierbar.

Die Impulserkennungsstufe besteht bei einer Ausführungsform der Erfindung aus einer am Netz anliegenden Reihenschaltung von Suppressordioden, wobei bei Überschreiten der Klemmspannung an einer ersten der Suppressordioden ein Signalpegel erzeugt wird, welcher auf den Mikrokontroller gelangt, um dann nach Signifikanzbewertung ein Triggersignal bereitzustellen bzw. auszulösen.

Bei einer weiteren Ausführungsvariante der Impulserkennungsstufe besitzt diese einen am Netz anliegenden Hochpass mit Suppressordioden, wobei der Hochpass mittels zugehörigem Widerstand und Kondensator so ausgelegt ist, dass bei vorgegebener Steilheit eines Spannungspegels ein Komparatoreingang des Mikrokontrollers einen Signalpegel erkennt, welcher triggerrelevant ist.

Mittels einer Suppressordiode im Hochpasszweig der Impulserkennungsstufe ist ein Mindestpegel oberhalb der Netzspannung zur weiteren Erfassung und Auswertung vorgebbar.

Die Erfindung soll nachstehend anhand von Ausführungsbeispielen sowie unter Zuhilfenahme von Figuren näher erläutert werden.

Hierbei zeigen:
- Fig. 1: ein Blockschaltbild der erfindungsgemäßen Lösung, insbesondere vorgesehen für den Einsatz bei einer Funkenstrecke mit Triggereingang;
- Fig. 2: ein Blockschaltbild der erfindungsgemäßen Lösung, insbesondere ausgebildet für einen Einsatz bei einem Dreielektroden-Gasableiter als Überspannungsableiter und
- Fig. 3: eine Prinzipdarstellung der Impulserkennung pegelsensitiv (linke Abbildung) sowie steilheitsabhängig mit Mindestpegel (rechte Abbildung).

Die in den Figuren dargestellte Schaltungsanordnung ist als aktive Schaltung bestehend aus schnellschaltenden Halbleiterbauelementen, die mit dem Triggereingang des jeweiligen Überspannungsableiters in Verbindung stehen, ausgeführt. Die jeweiligen Halbleiterbauelemente bzw. Leistungshalbleiter werden über eine Steuer- und Auswerteeinheit betrieben. Die Steuer- und Auswerteeinheit umfasst eine Impulserkennungsstufe 1 sowie einen Mikrokontroller 2. Der Mikrokontroller 2 ist an eine Spannungsversorgung 3, die am Niederspannungsnetz 4 anliegt, angeschlossen.

Ausgangsseitig steht der Mikrokontroller 2 mit dem Steuereingang eines Halbleiterschalters 5 in Verbindung.

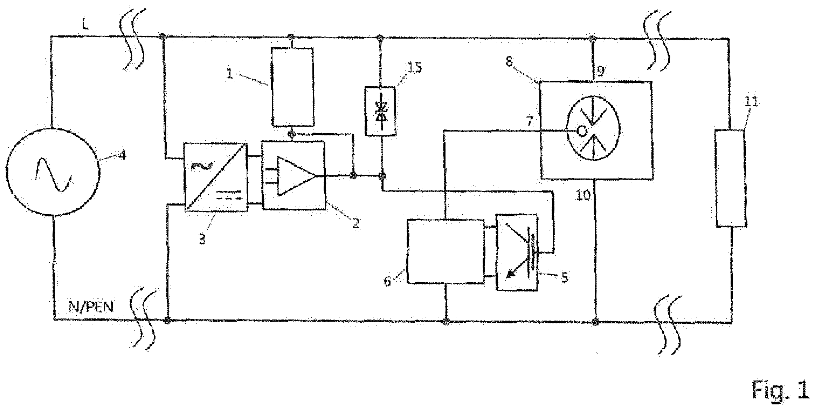

Gemäß Fig. 1 ist der Halbleiterschalter 5 über eine Baugruppe zur Impulsgleichrichtung 6, die als schnellschaltender Gleichrichter wirkt, mit dem Triggereingang 7 der Funkenstrecke 8 verbunden.

Die Hauptelektroden 9 und 10 der Funkenstrecke 8 liegen ebenfalls am Netz 4 an und stehen mit dem zu schützenden Verbraucher 11 in Verbindung.

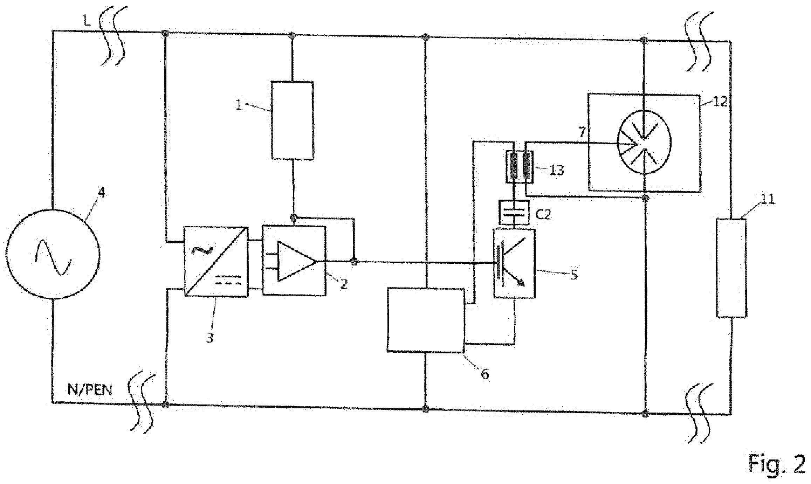

Bei der Ausführungsform nach Fig. 2 kommt als Überspannungsableiter ein Dreielektroden-Gasableiter 12 zum Einsatz, der ebenfalls einen Triggeranschluss 7 aufweist. Zusätzlich ist bei dieser Ausführungsform ein Übertrager 13 vorgesehen.

Die Spannungsversorgung 3, die mit dem Versorgungsnetz 4 in Verbindung steht, stellt die nötige Betriebsspannung für die Anordnung bereit. Die Spannungsversorgung 3 ist hierbei impulsfest ausgeführt und stellt sicher, dass keine Funktionsbeeinträchtigung während transienter Ereignisse, d.h. während des Ansprechens und Ableitens der Funkenstrecke sowie bei verketteter Spannung gegeben ist.

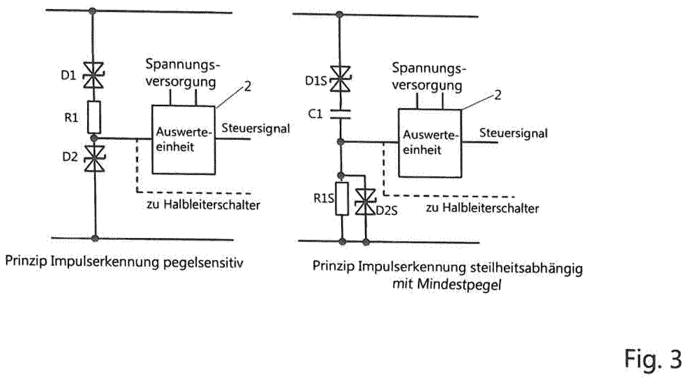

Bei Auftreten eines transienten Ereignisses wird über die Impulserkennungsschaltung 1 der Mikrokontroller 2 angesteuert. Die Impulserkennungsschaltung ist, wie in der Fig. 3 symbolisch dargestellt, entweder als Reihenschaltung von Suppressordioden D1 und D2 zur pegelsensitiven Impulserkennung (linke Abbildung) oder als Hochpass zur steilheitsabhängigen Impulserkennung (rechte Abbildung) ausgeführt.

Am Kollektor des Halbleiterschalters 5 gemäß Fig. 2 ist im Primärkreis des Übertragers 13 ein Kondensator C2 geschalten, um einen Netzfolgestrom zu begrenzen. Die Kapazität C2 wird durch eine Entladeschaltung nach Triggerung schnell entladen, so dass eine wiederkehrende Triggerung bzw. das Wiederherstellen der Betriebsbereitschaft in sehr kurzer Zeit möglich ist.

Es sei an dieser Stelle angemerkt, dass ganz grundsätzlich die Möglichkeit besteht, den oder die Leistungshalbleiter mit Gleichrichterschaltung nebst Auswerte- und Steuereinheit mechanisch in ein gemeinsames Gehäuse zu integrieren, so dass eine platzsparende, wenig Bauraum erfordernde Anordnung geschaffen werden kann.

Bei der Ausbildung der Reihenschaltung gemäß Fig. 3 unter Nutzung der Dioden D1, D2 und R1 (linke Abbildung) wird am Eingang des Mikrokontrollers 2 ein High-Pegel erzeugt, nachdem die Klemmenspannung der Diode D1 überschritten wurde.

Bei der Variante mit Hochpass (rechte Abbildung) wird dieser über die Elemente C1 und R1 so dimensioniert, dass ab einer gewissen Spannungssteilheit ein Eingang des Mikrokontrollers über den dort vorgesehenen Komparator einen High-Pegel erkennt. Dies erfolgt naturgemäß nur bei Pegeln oberhalb der Netzspannung, was durch die Diode D1S einstellbar ist.

Es hat sich gezeigt, dass trotz nur weniger Rechenoperationen bei üblichen 8 Bit Mikrokontrollern Verzögerungszeiten auftreten, die zu einem schlechteren Schutzpegel aufgrund der Signaldurchlaufzeiten und damit einem verspäteten Zuschalten des Triggerstroms führen.

Dies ist erfindungsgemäß dadurch verhinderbar, indem das Signal der Überspannungserkennung direkt an den Treiber im Mikrokontroller 2 oder direkt zum Leistungshalbleiter 5 geführt wird. Hierdurch ist ein sehr schnelles Ansteuern im Bereich von kleiner 50 ns möglich.

Bei sehr steilen Flanken ist es vorteilhaft, zur weiteren Anschaltzeitverringerung der Leistungshalbleiter diese im active clamping-Betrieb, symbolisiert durch die Baugruppe 15, zu versorgen.

Durch diese Arten der Voransteuerung wird bereits ein erster Triggerstrom sehr schnell in die Funkenstrecke geleitet.

Unter Berücksichtigung der Verarbeitungszeit übernimmt dann der Mikrokontroller 2 die weitere Steuerung und den dementsprechenden Betrieb. Zunächst schaltet der Mikrokontroller 2 bis zur sicheren Durchzündung der Funkenstrecke 8 bzw. des Dreielektroden-Gasableiters 12 den betreffenden Leistungshalbleiter 5 zu. Danach erfolgt zeitgesteuert ein Abschalten des Triggerpfads, damit ein möglicher Netzfolgestrom nicht über den Triggerpfad fließt. Hiernach ist der gesamte Triggerkreis wieder betriebsbereit.

Die erfindungsgemäße Lösung ermöglicht Schutzpegel unter 1 kV bei gewünschter TOV-Festigkeit, Die Impulserkennung selbst kann gestaffelt erfolgen, wodurch verschiedene Nennspannungen und darauf ein angepasster Schutzpegel möglich sind. Eine Einstellung kann sowohl fest herstellerseitig vorgeben sein, aber auch durch eine Voreinstellung im Sinne einer Programmierung des Kontrollers erfolgen.

Die vorgesehene Impulsgleichrichtung 6 führt zu einer Einsparung von Leistungshalbleitern, was sowohl den Platzbedarf der Schaltung als auch deren Kosten senkt.

Ein Grundschutz und eine Grundfunktion der Schaltungsanordnung ist auch bei nicht anliegender Betriebsspannung gewährleistet, da die Funkenstrecke quasi über Kopf durch die active-clamping-Betriebsart des Halbleiterschalters bzw. Leistungshalbleiters zünden kann.

Selbstverständlich können zum Erreichen höherer Triggerstromwerte auch mehrere Halbleiterbauelemente parallel geschaltet und von einer einzigen Ansteuerschaltung versorgt werden. Durch die Gleichrichtung entfällt die Ausbildung als bipolare Schaltungsanordnung. Um schnelle Schaltzeiten zu erreichen, kommen erfindungsgemäß diskrete, schnelle IGBT-Dioden zum Einsatz.

Erfindungsgemäß ist eine Triggerstromerfassung durch Nutzung des Mikrokontrollers 2 als Betriebszähler bzw. zu Diagnosezwecken möglich. Eine entsprechende Anzeige kann nach außen im Sinne einer Ansprecherkennung geführt werden.

Weiterhin kann der Ableitstrom des Überspannungsableiters nach Triggerung mit Hilfe des Mikrokontrollers überwacht, signalisiert und gespeichert werden. Diesbezüglich können in bekannter Weise Shunts, Hallelemente oder Ähnliches eingesetzt werden.

## Patentansprüche

1. Schaltungsanordnung zur elektronischen Ansteuerung von triggerbaren Überspannungsableitern wie Funkenstrecken (8) oder Mehrelektroden-Gasableiter (12), wobei mindestens ein Leistungshalbleiter (5) von einer Schaltstufe bei Erkennung eines Überspannungsereignisses aktiviert wird und der Leistungshalbleiter (5) ausgangsseitig mit einem Triggereingang (7) des Überspannungsableiters in Verbindung steht,
**dadurch gekennzeichnet, dass**
die Schaltstufe als Steuer- und Auswerteeinheit für die Erkennung transienter Überspannungsereignisse ausgebildet ist und erstens eine Impulserkennungsstufe (1) besitzt, welche eine Impulserkennung pegelsensitiv oder steilheitsabhängig ermöglicht, weiterhin zweitens einen Mikrokontroller (2) zur Ereignisbewertung aufweist, wobei der Mikrokontroller (2) ausgangsseitig auf den Steuerungseingang des Leistungshalbleiters (5) führt und zwischen dem Ausgang des Leistungshalbleiters (5) und dem Triggereingang (7) des Überspannungsableiters (8; 12) ein schnellschaltender Gleichrichter (6) auf der Basis diskreter, schneller IGBT-Dioden vorgesehen ist.

2. Schaltungsanordnung nach Anspruch 1,
**dadurch gekennzeichnet, dass**
zur Vermeidung eines verzögerten Aktivierens des Überspannungsableiters (8; 12) die Impulserkennungsstufe (1) unmittelbar auf den Steuerungseingang des Leistungshalbleiters (5) führt und/oder ein Clampingbetrieb (15) des Leistungshalbleiters (5) vorgesehen ist.

3. Schaltungsanordnung nach Anspruch 2,
**dadurch gekennzeichnet, dass**
nach einem schnellen Ansteuern des Leistungshalbleiters (5) im Bereich von im Wesentlichen kleiner 50 ns der Mikrokontroller (2) der Steuer- und Auswerteeinheit den weiteren Betrieb vorgibt, in dem ein sicheres Durchzünden des Überspannungsableiters (8; 12) und ein anschließendes zeitgesteuertes Abschalten des Triggerpfads (5; 6) vorgenommen wird.

4. Schaltungsanordnung nach einem der vorangegangenen Ansprüche,
**dadurch gekennzeichnet, dass**
zwischen dem Ausgang des Leistungshalbleiters (5) und dem Triggereingang (7) ein Übertrager (13) vorgesehen ist.

5. Schaltungsanordnung nach einem der vorangegangenen Ansprüche,
**dadurch gekennzeichnet, dass**
der Leistungshalbleiter(5) als IGBT, MosFET oder schnellschaltender Thyristor ausgebildet ist.

6. Schaltungsanordnung nach einem der vorangegangenen Ansprüche,
**dadurch gekennzeichnet, dass**
der Mikrokontroller (2) eine Einheit zur Speicherung und/oder Anzeige von Überspannungsereignissen mit Triggerauslösung aufweist.

7. Schaltungsanordnung nach einem der vorangegangenen Ansprüche,
**dadurch gekennzeichnet, dass**
die Ansprechspannung der Steuer- und Auswerteeinheit vorgebbar oder einstellbar ist.

8. Schaltungsanordnung nach einem der vorangegangenen Ansprüche,
**dadurch gekennzeichnet, dass**
die Impulserkennungsstufe (1) eine am Netz anliegende Reihenschaltung von Suppressordioden (D1, D2) aufweist, wobei beim Überschreiten der Klemmenspannung an einer ersten der Suppressordioden (D1) ein Signalpegel erzeugt wird, welcher auf den Mikrokontroller (2) gelangt.

9. Schaltungsanordnung nach einem der Ansprüche 1 bis 7,
**dadurch gekennzeichnet, dass**
die Impulserkennungsstufe (1) einen am Netz anliegenden Hochpass mit Suppressordioden (D1S und D2S) aufweist, wobei der Hochpass mittels eines Widerstands (R1S) und eines Kondensators (C1) so ausgelegt ist, dass bei vorgegebener Steilheit eines Spannungspegels ein Komparator des Mikrokontrollers (2) einen Signalpegel erkennt, welcher triggerrelevant ist.

10. Schaltungsanordnung nach Anspruch 9,
**dadurch gekennzeichnet, dass**
mittels einer Suppressordiode (D1S) im Hochpasszweig ein Mindestpegel oberhalb der Netzspannung vorgebbar ist.

## Claims

1. A circuit arrangement for electronically driving triggerable surge arresters such as spark gaps (8) or multi-electrode gas tube surge arresters (12), wherein at least one power semiconductor (5) is activated by a switching stage when an overvoltage event is detected and the power semiconductor (5) is connected on the output side to a trigger input (7) of the surge arrester,
**characterized in that**
the switching stage is configured as a control and evaluation unit for the detection of transient surge events and, firstly, has a pulse detection stage (1) which enables a pulse detection in a level-sensitive or steepness-dependent manner, and further, secondly, includes a microcontroller (2) for event assessment, the output side of the microcontroller (2) leading to the control input of the power semiconductor (5), and a fast-switching rectifier (6) based on discrete, fast IGBT diodes being provided between the output of the power semiconductor (5) and the trigger input (7) of the surge arrester (8; 12).

2. The circuit arrangement according to claim 1,
**characterized in that**
to avoid a delayed activation of the surge arrester (8; 12), the pulse detection stage (1) leads directly to the control input of the power semiconductor (5) and/or a clamping operation (15) of the power semiconductor (5) is provided.

3. The circuit arrangement according to claim 2,
**characterized in that**
after a quick driving of the power semiconductor (5) in the range of essentially less than 50 ns, the microcontroller (2) of the control and evaluation unit specifies the further operation, in which a safe arcing of the surge arrester (8; 12) and a subsequent time-controlled disconnection of the trigger path (5; 6) are performed.

4. The circuit arrangement according to any of the preceding claims,
**characterized in that**
a transformer (13) is provided between the output of the power semiconductor (5) and the trigger input (7).

5. The circuit arrangement according to any of the preceding claims,
**characterized in that**
the power semiconductor (S) is in the form of an IGBT, a MosFET or a fast-switching thyristor.

6. The circuit arrangement according to any of the preceding claims,
**characterized in that**
the microcontroller (2) includes a unit for storing and/or displaying surge events with trigger release.

7. The circuit arrangement according to any of the preceding claims,
**characterized in that**
the response voltage of the control and evaluation unit is specifiable or adjustable.

8. The circuit arrangement according to any of the preceding claims,
**characterized in that**
the pulse detection stage (1) includes a series circuit, connected to the mains, of transient voltage suppression diodes (D1, D2), wherein when the terminal voltage at a first one of the transient voltage suppression diodes (D1) is exceeded, a signal level is generated which reaches the microcontroller (2).

9. The circuit arrangement according to any of claims 1 to 7,
**characterized in that**
the pulse detection stage (1) includes a high-pass filter, connected to the mains, having transient voltage suppression diodes (D1S and D2S), wherein the high-pass filter is designed by means of a resistor (R1S) and a capacitor (C1) such that, for a specified steepness of a voltage level, a comparator of the microcontroller (2) detects a signal level which is trigger-relevant.

10. The circuit arrangement according to claim 9,
**characterized in that**
a minimum level above the mains voltage is specifiable by means of a transient voltage suppression diode (D1S) in the high-pass filter branch.

## Revendications

1. Agencement de circuit pour le pilotage électronique de parasurtenseurs déclenchables tels que des éclateurs (8) ou des éclateurs à gaz à plusieurs électrodes (12), au moins un semi-conducteur de puissance (5) étant activé par un étage de commutation lors de la détection d'un évènement de surtension, et le semi-conducteur de puissance (5) étant en communication, du côté sortie, avec une entrée de déclenchement (7) du parasurtenseur,
**caractérisé en ce que**
l'étage de commutation est réalisé sous forme d'unité de commande et d'évaluation pour la détection d'évènements de surtension transitoires et présente, premièrement, un étage de détection d'impulsion (1) qui permet une détection d'impulsion de manière sensible au niveau ou en fonction de la pente, et, deuxièmement, un microcontôleur (2) pour l'évaluation de l'évènement, le microcontrôleur (2) menant, du côté sortie, sur l'entrée de commande du semi-conducteur de puissance (5), et un redresseur (6) à commutation rapide sur la base de diodes IGBT discrètes et rapides étant prévu entre la sortie du semi-conducteur de puissance (5) et l'entrée de déclenchement (7) du parasurtenseur (8 ; 12).

2. Agencement de circuit selon la revendication 1,
**caractérisé en ce que**
pour éviter une activation retardée du parasurtenseur (8; 12), l'étage de détection d'impulsion (1) mène directement sur l'entrée de commande du semi-conducteur de puissance (5) et/ou il est prévu un fonctionnement de verrouillage (15) du semi-conducteur de puissance (5).

3. Agencement de circuit selon la revendication 2,
**caractérisé en ce que**
après un pilotage rapide du semi-conducteur de puissance (5) dans la plage sensiblement inférieure à 50 ns, le microcontrôleur (2) de l'unité de commande et d'évaluation détermine le fonctionnement ultérieur lors duquel un amorçage sûr du parasurtenseur (8 ; 12) et ensuite un arrêt commandé dans le temps du chemin de déclenchement (5 ; 6) sont effectués.

4. Agencement de circuit selon l'une des revendications précédentes,
**caractérisé en ce que**
un transformateur (13) est prévu entre la sortie du semi-conducteur de puissance (5) et l'entrée de déclenchement (7).

5. Agencement de circuit selon l'une des revendications précédentes,
**caractérisé en ce que**
le semi-conducteur de puissance (5) est réalisé sous forme d'IGBT, de MosFET ou de thyristor à commutation rapide.

6. Agencement de circuit selon l'une des revendications précédentes,
**caractérisé en ce que**
le microcontrôleur (2) présente une unité de mémorisation et/ou d'affichage d'évènements de surtension à déclenchement par trigger.

7. Agencement de circuit selon l'une des revendications précédentes,
**caractérisé en ce que**
la tension de réponse de l'unité de commande et d'évaluation peut être déterminée ou réglée.

8. Agencement de circuit selon l'une des revendications précédentes,
**caractérisé en ce que**
l'étage de détection d'impulsion (1) présente un couplage en série de diodes de suppression (D1 et D2) appliqué au réseau, un niveau de signaux parvenant sur le microcontrôleur (2) étant généré lors d'un dépassement de la tension aux bornes au niveau d'une première des diodes de suppression (D1).

9. Agencement de circuit selon l'une des revendications 1 à 7,
**caractérisé en ce que**
l'étage de détection d'impulsion (1) présente un filtre passe-haut avec des diodes de suppression (D1S et D2S) appliqué au réseau, le filtre passe-haut étant aménagé au moyen d'une résistance (R1S) et d'un condensateur (C1) de telle sorte qu'un comparateur du microcontrôleur (2) détecte un niveau de signaux influençant le déclenchement pour une pente prédéterminée d'un niveau de tension.

10. Agencement de circuit selon la revendication 9,
**caractérisé en ce que**
un niveau minimum supérieur à la tension de réseau peut être déterminé au moyen d'une diode de suppression (D1S) dans la branche de filtre passe-haut.
